# EUROPEAN PATENT APPLICATION

(11) **EP 3 757 175 A1**
(43) Date of publication of application: **30.12.2020**
(21) Application number: 19183177.5
(22) Date of filing: 28.06.2019
(51) Int. Cl.: C09D 11/101, B29C 64/40, C09D 11/30, G03F 7/027, H05K 3/06

(54) **RADIATION CURABLE INKJET INK FOR ALKALINE ETCHING OR PLATING APPLICATIONS**

(71) Applicant: AGFA-GEVAERT NV, 2640 Mortsel (BE)
(72) Inventor: LOCCUFIER, Johan, 2640 Mortsel (BE)
(74) Representative: Viaene, Kris

(57) **Abstract**

A radiation curable composition comprising:
- a monomer including at least two polymerisable groups wherein a linking group between the polymerisable groups comprises at least one acid degradable or hydrolysable group selected from the group consisting of an acetal, a ketal, an orthoester, an orthocarbonate, a tertiary ester, a tertiary carbonate and a tertiary urethane, and
- a nitrogen containing monofunctional monomer of which the pKa of the conjugated acid is at least 3.5, and
wherein the composition further comprises less than 10 wt% of other monomers including at least two polymerisable groups relative to the total weight of the polymerisable composition.

## Description

### Technical field of the invention

The present invention relates to an acid degradable radiation curable composition for use in alkaline etching or plating applications.

### Background art for the invention

Etch resist technology is evolving from an analogue work flow towards a digital work flow as the latter allows to reduce the number of production steps in different etch applications such as PCB production and the manufacturing of precision parts and decorative elements. A digital workflow further enables the possibility for short run manufacturing or even the production of individual elements without a significant increase of the cost. Going from an analogue to a digital workflow has clear economical and ecological benefits.

Inkjet is one of the preferred technologies to design digital etch resists and a lot of effort has been directed towards the design of inkjet etch resist inks, mainly based on UV curable technology.

Most UV curable etch resist inkjet inks have been designed for acid etching and alkaline stripping.

WO2004/026977 (Avecia) discloses a non-aqueous etch resistant inkjet ink comprising 1 to 30 wt% of an acrylate functional monomer containing one or more acidic group as an adhesion promoter and a dissolution promoter during stripping.

WO2004/106437 (Avecia) discloses an etch resistant inkjet ink preferably comprising (meth)acrylate acid adhesion promoters, such as (meth)acrylated carboxylic acids, (meth)acrylated phosphoric acid esters and (meth)acrylated sulphonic acids.

WO2016/050371 (Agfa Gevaert NV) discloses a method for manufacturing metallic articles comprising an electroplating or an acidic etching step.

WO2016/050372 (Agfa Gevaert NV and AGFA NV) disclose a method for manufacturing embossing elements comprising an acidic etching step.

WO2016/050504 (Agfa Gevaert NV) discloses a UV curable ink jet ink with etch resistance, comprising specific acidic adhesion promoters.

WO2017/148810 (Agfa Gevaert NV) disclose a method for manufacturing etched glass articles, using an acidic etch step.

All disclosed etch resistant inkjet inks are compatible with an acidic to slightly alkaline etching step, followed by a moderate to strong alkaline stripping step.

However, different metals may be preferably etched in medium to strong alkaline conditions.

US2017/0120515 and WO2017/048710 (Carbon Inc.) disclose a polymerizable liquid composition useful for additive manufacturing comprising a free radical photoinitiator, monomers and/or prepolymers, a chain extender or crosslinker, and a photoacid generator, wherein optionally some or all of the monomers and/or prepolymers, chain extender or crosslinker comprise one or more acid-labile groups and wherein the monomers and/or prepolymers, the chain extender or crosslinker comprising the acid-labile group on one hand and the photoinitiator and the photoacid generator on the other hand are activated by light at different wavelengths or intensities.

To extend the scope of applications of digital etch resist technology there is a need for an inkjet ink yielding an alkaline resistant etch resist that can be stripped under acidic conditions.

Now it has been found that a radiation curable composition according to the present invention can realize the objects of the present invention.

### Summary of the invention

It is an object of the invention to provide a radiation curable composition capable of forming an alkaline resistant etch resist that can be removed in acidic conditions.

That object of the invention is realized by the radiation curable inkjet ink according to claim 1.

Further objects of the invention will become apparent from the description hereinafter.

### Detailed description of the invention

### Definitions

The term "monofunctional" in e.g. monofunctional polymerizable compound means that the polymerizable compound includes one polymerizable group.

The term "difunctional" in e.g. difunctional polymerizable compound means that the polymerizable compound includes two polymerizable groups.

The term "polyfunctional" in e.g. polyfunctional polymerizable compound means that the polymerizable compound includes more than two polymerizable groups.

The term "alkyl" means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl, etc.

Unless otherwise specified a substituted or unsubstituted alkyl group is preferably a C₁ to C₆-alkyl group.

Unless otherwise specified a substituted or unsubstituted alkenyl group is preferably a C₂ to C₆-alkenyl group.

Unless otherwise specified a substituted or unsubstituted alkynyl group is preferably a C₂ to C₆-alkynyl group.

Unless otherwise specified a substituted or unsubstituted alkaryl group is preferably a phenyl or naphthyl group including one, two, three or more C₁ to C₆-alkyl groups.

Unless otherwise specified a substituted or unsubstituted aralkyl group is preferably a C₇ to C₂₀-alkyl group including a phenyl group or naphthyl group.

Unless otherwise specified a substituted or unsubstituted aryl group is preferably a phenyl group or naphthyl group.

Unless otherwise specified a substituted or unsubstituted heteroaryl group is preferably a five- or six-membered ring substituted by one, two or three oxygen atoms, nitrogen atoms, sulphur atoms, selenium atoms or combinations thereof.

The term "substituted", in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.

Unless otherwise specified a substituted alkyl group, a substituted alkenyl group, a substituted alkynyl group, a substituted aralkyl group, a substituted alkaryl group, a substituted aryl and a substituted heteroaryl group are preferably substituted by one or more constituents selected from the group consisting of methyl, ethyl, n-propyl, isopropyl, n-butyl, isobutyl and tertiary-butyl, ester, amide, ether, thioether, ketone, aldehyde, sulfoxide, sulfone, sulfonate ester, sulphonamide, -CI, -Br, -I, - OH, -SH, -CN and -NO₂.

### Radiation curable composition

The radiation curable composition comprises:
- a monomer including at least two polymerisable groups characterized in that a linking group between the polymerisable groups comprises at least one acid degradable or hydrolysable group selected from the group consisting of an acetal, a ketal, an orthoester, an orthocarbonate, a tertiary ester, a tertiary carbonate and a tertiary urethane,
- a nitrogen containing monofunctional monomer having a pKa of the conjugated acid of 3.5 or more,
and wherein the composition further comprises less than 10 wt% of other monomers including at least two polymerisable groups relative to the total weight of the polymerisable composition.

The radiation curable composition may further comprise other ingredients such as a photoinitiating system, colorants, polymeric dispersants, a polymerization inhibitor, a flame retardant or a surfactant.

The radiation curable composition may be cured by any type of radiation, for example by electron-beam radiation, but is preferably cured by UV radiation, more preferably by UV radiation from UV LEDs. The radiation curable composition is thus preferably a UV curable composition.

The radiation curable composition is preferably a radiation curable inkjet ink.

For reliable industrial inkjet printing, the viscosity of the radiation curable inkjet ink is preferably no more than 20 mPa.s at 45°C, more preferably between 1 and 18 mPa.s at 45°C, and most preferably between 4 and 14 mPa.s at 45°C, all at a shear rate of 1000 s⁻¹.

A preferred jetting temperature is between 10 and 70°C, more preferably between 20 and 55°C, and most preferably between 25 and 50°C.

For good image quality and adhesion, the surface tension of the radiation curable inkjet ink is preferably in the range of 18 to 70 mN/m at 25°C, more preferably in the range of 20 to 40 mN/m at 25°C.

### Di-or multifunctional monomer

The radiation curable composition comprises a monomer including at least two polymerisable groups characterized in that a linking group between the polymerisable groups comprises at least one acid degradable or hydrolysable group selected from the group consisting of an acetal, a ketal, an orthoester, an orthocarbonate, a tertiary ester, a tertiary carbonate and a tertiary urethane and wherein the composition further comprises less than 10 wt% of other monomers including at least two polymerisable groups relative to the total weight of the polymerisable composition.

The polymerizable groups are preferably ethylenically unsaturated groups.

The ethylenically unsatured groups are preferable selected from the group consisting of an acrylate, a methacrylate, an acrylamide and a methacrylamide. The ethylenically unsaturated group is more preferably an acrylate or a methacrylate group, most preferably an acrylate group.

The linking group preferably comprises an acid degradable or hydrolysable group selected from the group consisting of an acetal, a ketal, an orthoester and a tertiary ester, an acetal and a ketal being more preferred, an acetal being the most preferred.

The monomer including at least two polymerisable groups and wherein the linking group between the polymerisable groups comprises at least one acid degradable or hydrolysable group comprising an acid degradable or hydrolysable group preferably has a chemical structure according to Formula I : 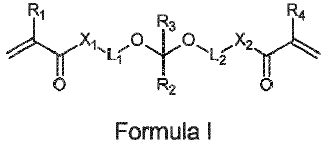 wherein
R₁ and R₄ are independently selected from the group consisting of a hydrogen and a C1 to C4 alkyl group;
R₂ and R₃ are independently selected from the group consisting of a hydrogen, a substituted or unsubstituted alkyl group, a substituted or unsubstituted alkenyl group, a substituted or unsubstituted alkynyl group and a substituted or unsubstituted (hetero)aryl group;
R₂ and R₃ may represent the necessary atoms to form a five to eight membered ring;
L₁ and L₂ independently represent a divalent linking group comprising 10 carbon atoms or less;
X₁ and X₂ are independently selected from the group consisting of an oxygen and R₅N;
R₅ is selected from the group consisting of a hydrogen and a substituted or unsubstituted alkyl group.

R₁ and R₄ preferably independently represent a hydrogen or a methyl group, more preferably a hydrogen.

R₂ and R₃ preferably independently represent a hydrogen or an alkyl group, more preferably a hydrogen and a C₁ to C₄ alkyl group.

X₁ and X₂ preferably represent an oxygen.

According to another preferred embodiment the monomer including at least two polymerisable groups and wherein the linking group between the polymerisable groups comprises at least one acid degradable or hydrolysable group has a chemical structure according to Formula II: 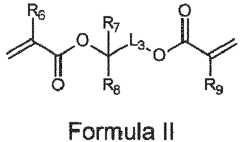 wherein
R₆ and R₉ are independently selected from the group consisting of a hydrogen and a C1 to C4 alkyl group
R₇ and R₈ are independently selected from the group consisting of a substituted or unsubstituted alkyl group, a substituted or unsubstituted alkenyl group, a substituted or unsubstituted alkynyl group and a substituted or unsubstituted (hetero)aryl group. R₇ and R₈ may represent the necessary atoms to form a five to eight membered ring
L₃ represent represent a divalent linking group comprising 20 carbon atoms or less.

R₆ and R₉ preferably independently represent a hydrogen or a methyl group, more preferably a hydrogen.

R₇ and R₈ preferably independently represent an alkyl group, more preferably a C₁ to C₄ alkyl group.

Typical monomers including at least two polymerisable groups and wherein the linking group between the polymerisable groups comprises at least one acid degradable or hydrolysable group according to the invention are given below without being limited thereto.

**Table 1**

| | |
|---|---|
| 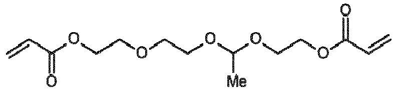 | Crosslinker-1 |
| 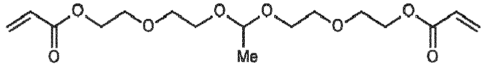 | Crosslinker-2 |
| 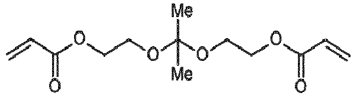 | Crosslinker-3 |
| 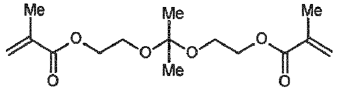 | Crosslinker-4 |
| 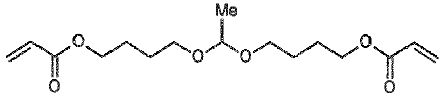 | Crosslinker-5 |
| 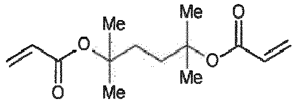 | Crosslinker-6 |
| 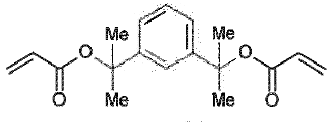 | Crosslinker-7 |
| 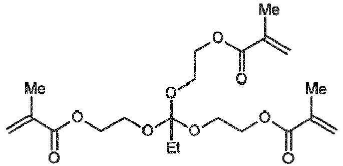 | Crosslinker-8 |
| 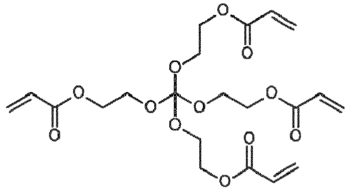 | Crosslinker-9 |
| 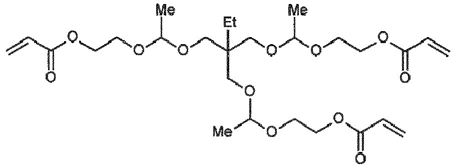 | Crosslinker-10 |
| 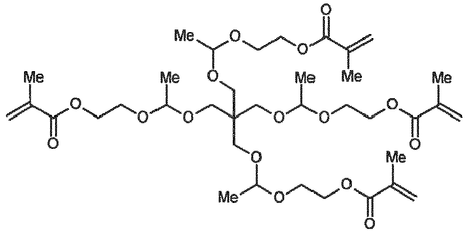 | Crosslinker-11 |
| 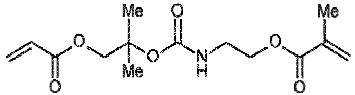 | Crosslinker-12 |
| 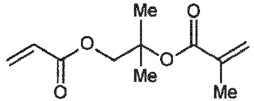 | Crosslinker-13 |
| 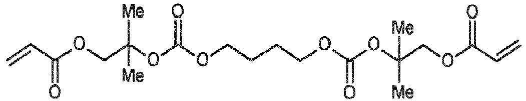 | Crosslinker-14 |
| 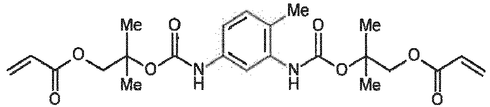 | Crosslinker-15 |

The amount of monomers including at least two polymerisable groups and wherein the linking group between the polymerisable groups comprises at least one acid degradable or hydrolysable group of is preferably not less than 25 wt%, more preferably between 35 and 60 wt%, relative to the total weight of the radiation curable composition.

In a particularly preferred embodiment the radiation curable composition according to the present invention comprises less than 10 w%, relative to the total weight of the radiation curable composition, other monomers including at least two polymerisable groups.

Most preferably, the radiation curable composition is substantially free of other monomers including at least two polymerisable groups.

### Nitrogen containing monomer

The radiation curable composition comprises a nitrogen containing monofunctional monomer having a pKa of the conjugated acid of 3.5 or more.

More preferably, the nitrogen containing monomer has a pKa of the conjugated acid of at least 7, most preferably of at least 9.

A preferred nitrogen containing monomer has a functional group selected from the group consisting of a tertiary amine, a pyridine and an imidazole group.

Typical nitrogen containing monomers according to the present invention are given below without being limited thereto.

**Table 2**

| | |
|---|---|
| 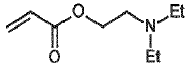 | Amine-1 |
| 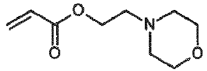 | Amine-2 |
| 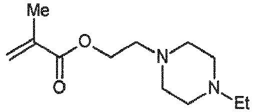 | Amine-3 |
| 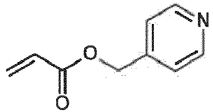 | Amine-4 |
| 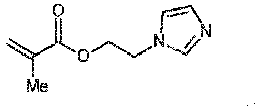 | Amine-5 |
| 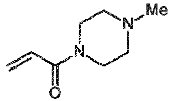 | Amine-6 |
| 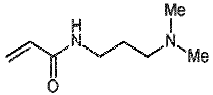 | Amine-7 |
| 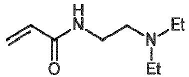 | Amine-8 |
| 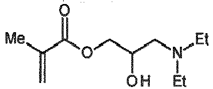 | Amine-9 |
| 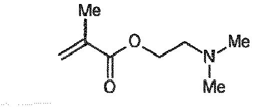 | Amine-10 |
| 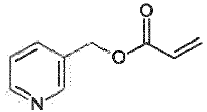 | Amine-11 |

The amount of the nitrogen containing monomer is preferably between 1 and 25 wt%, more preferably between 2 and 15 wt% and most preferably between 3 and 10 wt%, relative to the total weight of the radiation curable composition.

### Other monomers

The radiation curable composition may in addition to the monomer including at least two polymerisable groups and wherein the linking group between the polymerisable groups comprises at least one acid degradable or hydrolysable group and the nitrogen containing monomers described above comprise other monomers, oligomers and/or prepolymers.

In a preferred embodiment, such monomers, oligomers or prepolymers include an acrylate group as polymerizable group.

Preferred monomers and oligomers are those listed in paragraphs [0106] to [0115] in EP-A 1911814.

The other monomers are preferably monofunctional monomers, more preferably monofunctional acrylates or methacrylates.

### Photoinitiators

The radiation curable curable composition preferably contains a photoinitiator.

A free radical photoinitiator is a chemical compound that initiates polymerization of monomers and oligomers when exposed to actinic radiation by the formation of a free radical. A Norrish Type I initiator is an initiator which cleaves after excitation, yielding the initiating radical immediately. A Norrish type II-initiator is a photoinitiator which is activated by actinic radiation and forms free radicals by hydrogen abstraction from a second compound that becomes the actual initiating free radical. This second compound is called a polymerization synergist or co-initiator. Both type I and type II photoinitiators can be used in the present invention, alone or in combination.

Suitable photoinitiators are disclosed in CRIVELLO, J.V., et al. Photoinitiators for Free Radical, Cationic and Anionic Photopolymerization. 2nd edition. Edited by BRADLEY, G.. London, UK: John Wiley and Sons Ltd, 1998. p.276-293.

Specific examples of free radical photoinitiators may include, but are not limited to, the following compounds or combinations thereof: benzophenone and substituted benzophenones; 1-hydroxycyclohexyl phenyl ketone; thioxanthones such as isopropylthioxanthone; 2-hydroxy-2-methyl-1-phenylpropan-1-one; 2-benzyl-2-dimethylamino- (4-morpholinophenyl) butan-1-one; benzyl dimethylketal; bis (2,6-dimethylbenzoyl)-2,4,4-trimethylpentylphosphine oxide; 2,4,6 trimethylbenzoyldiphenylphosphine oxide; 2,4,6-trimethoxybenzoyldiphenylphosphine oxide;

2-methyl-1- [4- (methylthio) phenyl] -2-morpholinopropan-1-one; 2,2-dimethoxy-1, 2-diphenylethan-1-one or 5,7-diiodo-3- butoxy-6-fluorone.

Suitable commercial free radical photoinitiators include for example the Omnirad™, Ominpol™ and Esacure™type photoinitiators from IGM. Examples of such photoinitiators are Omnirad 379, Omnirad 369, Omnirad 819, Omnirad 184, Omnirad 2959 and Esacure KIP 150.

A preferred amount of photoinitiator is 0.1 - 20 wt%, more preferably 2 - 15 wt%, and most preferably 3 - 10 wt% of the total weight of the radiation curable inkjet ink.

In order to increase the photosensitivity further, the radiation curable inkjet may additionally contain co-initiators. Suitable examples of co-initiators can be categorized in three groups: 1) tertiary aliphatic amines such as methyldiethanolamine, dimethylethanolamine, triethanolamine, triethylamine and N-methylmorpholine; (2) aromatic amines such as amylparadimethyl-aminobenzoate, 2-n-butoxyethyl-4-(dimethylamino) benzoate, 2-(dimethylamino)-ethylbenzoate, ethyl-4-(dimethylamino)benzoate, and 2-ethylhexyl-4-(dimethylamino)benzoate; and (3) (meth)acrylated amines such as dialkylamino alkyl(meth)acrylates (e.g., diethylaminoethylacrylate) or N-morpholinoalkyl-(meth)acrylates (e.g., N-morpholinoethyl-acrylate). The preferred co-initiators are aminobenzoates.

### Colorants

The radiation curable inkjet may be a substantially colourless inkjet ink or may include at least one colorant. For example when the inkjet ink is used as etch resist, the colorant makes the temporary mask clearly visible to the manufacturer of conductive patters, allowing a visual inspection of quality. When the inkjet ink is used to apply a solder mask it typically contains a colorant. A preferred colour for a solder mask is green, however other colours such as black or red may also be used.

The colorant may be a pigment or a dye, but is preferably a pigment.

A colour pigment may be chosen from those disclosed by HERBST, Willy, et al. Industrial Organic Pigments, Production, Properties, Applications, 3rd edition. Wiley - VCH, 2004, ISBN 3527305769.

Suitable pigments are disclosed in paragraphs [0128] to [0138] of WO2008/074548.

Pigment particles in inkjet inks should be sufficiently small to permit free flow of the ink through the inkjet-printing device, especially at the ejecting nozzles. It is also desirable to use small particles for maximum colour strength and to slow down sedimentation. Most preferably, the average pigment particle size is no larger than 150 nm. The average particle size of pigment particles is preferably determined with a Brookhaven Instruments Particle Sizer BI90plus based upon the principle of dynamic light scattering.

In PCBs, the solder mask typically has a blue or green colour. The blue pigment is preferably one of the phthalocyanine series. Examples of blue pigments are C.I. Pigment Blue 1, 15, 15:1, 15:2, 15:3, 15:4, 15:6, 16, 24 and 60.

Green pigments are generally a mixture of blue and yellow or orange pigments or may be green pigments or dyes per se, such as halogenated phthalocyanines, for example copper or nickel brominated phthalocyanine.

In a preferred embodiment, the colorant is present in an amount of 0.2 to 6.0 wt%, more preferably 0.5 to 2.5 wt%, based on the total weight of the radiation curable inkjet ink.

### Polymeric Dispersants

If the colorant in the radiation curable inkjet is a pigment, then the radiation curable inkjet ink preferably contains a dispersant, more preferably a polymeric dispersant, for dispersing the pigment.

Suitable polymeric dispersants are copolymers of two monomers but they may contain three, four, five or even more monomers. The properties of polymeric dispersants depend on both the nature of the monomers and their distribution in the polymer. Copolymeric dispersants preferably have the following polymer compositions:
statistically polymerized monomers (e.g. monomers A and B polymerized into ABBAABAB);
alternating polymerized monomers (e.g. monomers A and B polymerized into ABABABAB);
gradient (tapered) polymerized monomers (e.g. monomers A and B polymerized into AAABAABBABBB);
block copolymers (e.g. monomers A and B polymerized into AAAAABBBBBB) wherein the block length of each of the blocks (2, 3, 4, 5 or even more) is important for the dispersion capability of the polymeric dispersant;
graft copolymers (graft copolymers consist of a polymeric backbone with polymeric side chains attached to the backbone); and
mixed forms of these polymers, e.g. blocky gradient copolymers.

Suitable polymeric dispersants are listed in the section on "Dispersants", more specifically [0064] to [0070] and [0074] to [0077], in EP-A 1911814.

Commercial examples of polymeric dispersants are the following:
DISPERBYK™ dispersants available from BYK CHEMIE GMBH;
SOLSPERSE™ dispersants available from NOVEON;
TEGOTM DISPERS™ dispersants from EVONIK;
EDAPLAN™ dispersants from MÜNZING CHEMIE;
ETHACRYL™ dispersants from LYONDELL;
GANEX™ dispersants from ISP;
DISPEX™ and EFKA™ dispersants from CIBA SPECIALTY CHEMICALS INC;
DISPONER™ dispersants from DEUCHEM; and
JONCRYL™ dispersants from JOHNSON POLYMER.

### Polymerization Inhibitors

The radiation curable inkjet ink may contain at least one inhibitor for improving the thermal stability of the ink.

Suitable polymerization inhibitors include phenol type antioxidants, hindered amine light stabilizers, phosphor type antioxidants, hydroquinone monomethyl ether commonly used in (meth)acrylate monomers, and hydroquinone. t-butylcatechol, pyrogallol, 2,6-di-tert.butyl-4-methylphenol (=BHT) and phenothiazine may also be used.

Suitable commercial inhibitors are, for example, Sumilizer™ GA-80, Sumilizer™ GM and Sumilizer™ GS produced by Sumitomo Chemical Co. Ltd.; Genorad™ 16, Genorad™18 and Genorad™ 22 from Rahn AG; Irgastab™UV10 and Irgastab™ UV22, Tinuvin™ 460 and CGS20 from Ciba Specialty Chemicals; Florstab™ UV range (UV-1, UV-2, UV-5 and UV-8) from Kromachem Ltd, AdditolTM S range (S100, S110, S120 and S130) and PTZ from Cytec Solvay Group.

The inhibitor is preferably a polymerizable inhibitor.

Since excessive addition of these polymerization inhibitors may lower the curing speed, it is preferred that the amount capable of preventing polymerization is determined prior to blending. The amount of a polymerization inhibitor is preferably lower than 5 wt%, more preferably lower than 3 wt% of the total radiation curable inkjet ink.

### Surfactants

The radiation curable inkjet may contain at least one surfactant, but preferably no surfactant is present.

The surfactant can be anionic, cationic, non-ionic, or zwitter-ionic and is usually added in a total quantity less than 1wt% based on the total weight of the radiation curable inkjet ink.

Suitable surfactants include fluorinated surfactants, fatty acid salts, ester salts of a higher alcohol, alkylbenzene sulfonate salts, sulfosuccinate ester salts and phosphate ester salts of a higher alcohol (for example, sodium dodecylbenzenesulfonate and sodium dioctylsulfosuccinate), ethylene oxide adducts of a higher alcohol, ethylene oxide adducts of an alkylphenol, ethylene oxide adducts of a polyhydric alcohol fatty acid ester, and acetylene glycol and ethylene oxide adducts thereof (for example, polyoxyethylene nonylphenyl ether, and SURFYNOL™ 104, 104H, 440, 465 and TG available from AIR PRODUCTS & CHEMICALS INC.).

Preferred surfactants are selected from fluoric surfactants (such as fluorinated hydrocarbons) and silicone surfactants. The silicone surfactants are preferably siloxanes and can be alkoxylated, polyether modified, polyether modified hydroxy functional, amine modified, epoxy modified and other modifications or combinations thereof. Preferred siloxanes are polymeric, for example polydimethylsiloxanes.

Preferred commercial silicone surfactants include BYK™ 333 and BYK™ UV3510 from BYK Chemie and Tego Rad 2100 from Evonik Industries.

In a preferred embodiment, the surfactant is a polymerizable compound.

Preferred polymerizable silicone surfactants include a (meth)acrylated silicone surfactant. Most preferably the (meth)acrylated silicone surfactant is an acrylated silicone surfactant, because acrylates are more reactive than methacrylates.

In a preferred embodiment, the (meth)acrylated silicone surfactant is a polyether modified (meth)acrylated polydimethylsiloxane or a polyester modified (meth)acrylated polydimethylsiloxane.

Preferably the surfactant is present in the radiation curable inkjet ink in an amount of 0 to 3 wt% based on the total weight of the radiation curable inkjet ink.

### Flame retardant

Preferred flame retardants are inorganic flame retardants, such as Alumina Trihydrate and Boehmite, and organo-phosphor compounds, such as organo-phosphates (e.g. triphenyl phosphate (TPP), resorcinol bis (diphenylphosphate) (RDP), bisphenol A diphenyl phosphate (BADP), and tricresyl phosphate (TCP)); organo-phosphonates (e.g. dimethyl methylphosphonate (DMMP)); and organophosphinates (e.g. aluminium dimethylphosphinate).

Other preferred organo-phosphor compounds are disclosed in US8273805.

### Preparation of Inkjet Inks

The preparation of pigmented radiation curable inkjet inks is well-known to the skilled person. Preferred methods of preparation are disclosed in paragraphs [0076] to [0085] of WO2011/069943.

### Method of manufacturing a metallic article

The method of manufacturing metallic articles (6) includes the steps of:
- applying a radiation curable composition as described above on a surface of a substrate thereby forming an image (2);
- curing the image;
- plating (4) or etching (3) a surface of the substrate not covered by the cured image by means of an alkaline solution;
- removing (5) at least part of the cured image by means of an acidic solution.

The radiation curable composition maybe referred to as respectively a plating resist or an etch resist when the method includes a plating step (4) or an etching step (3).

### Etching

An etch resist is provided on a metal surface by applying and curing the radiation curable composition on the metal surface thereby forming a cured image on the metal surface. Metal from the metal surface not covered by the cured image is then removed by etching.

After etching, at least part of the cured image removed from the metal surface.

The metal surface is preferably a metal foil or metal sheet attached to a substrate.

There is no real limitation on the type of substrate bonded to the metal sheet. The substrates may be made of a ceramic, glass or plastics, such as polyimides.

The metal sheet usually has a thickness between 9 and 105 µm.

There is no limitation on the nature of the metal surface. The metal surfaces preferably consist of copper, aluminium, nickel, iron, tin, titanium or zinc, but may be also alloys including these metals.

Copper has a high electrical conductivity and is a relatively cheap metal, making it very suitable for making printed circuit boards.

The method may also be used for manufacturing a decorative etched metal panel.

In this case, preferably a solid metal panel is used. However, also a metal foil attached to a substrate may be used. There is no real limitation on the type of substrate bonded to the metal foil. The substrates may be made of a ceramic, glass or plastics, or even a second (cheaper) metal plate. The metal may also be an alloy.

Such a decorative metal panel may serve a purpose other than being purely decorative, such as providing information. For example, an aluminium name plate wherein the etch resistant radiation curable inkjet ink was printed as information, such as a name of a person or a company, and then removed to result in a glossy shiny name on a mat etched background, is also considered a decorative metal panel including a decorative element. Etching causes a change in optical properties of a metal surface, such as a change of gloss. After removal of the cured radiation curable inkjet ink from the metal surface an aesthetic effect is created between the etched and the non-etched metal surface.

The metal surface is preferably cleaned before applying the radiation curable composition. This is especially desirable when the metal surface is handled by hand and no gloves are worn. The cleaning removes dust particles and grease which can interfere in the adhesion of the radiation curable composition to the metal surface. In PCB the copper is often cleaned by microetching. The oxide layer of the copper is removed and roughness introduced in order to improve the adhesion.

The method may also be used for manufacturing a decorative etched glass panel. Such a method is disclosed in for example WO2013/189762 (AGC).

The radiation curable composition may be cured in both embodiments by exposing the composition to actinic radiation, such as electron beam or ultraviolet (UV) radiation. Preferably the radiation curable composition is cured by UV radiation, more preferably using UV LED curing.

In a particular preferred embodiment, the radiation curable composition is applied on the substrate by means of inkjet printing.

Alkaline etching is carried out in an alkaline aqueous solution having a pH between 8 and 14, preferably having a pH of at least 9, more preferably at least 10, most preferably at least 11.

The alkaline etchant preferably includes at least one base selected from the group consisting of ammonia or ammonium hydroxide, potassium hydroxide and sodium hydroxide.

Etching of a metal surface is preferably performed in a time frame of seconds to a few minutes, more preferably 5 to 200 seconds. Etching is preferably performed at a temperature between 35 and 60°C.

The etching time of a metal surface in other applications, such as in the manufacture of decorative metal panels, may be substantially longer, depending on the type and amount of metal that has to be removed during the etch step. Etching times may be more then 15, 30 or even 60 minutes.

Etching is preferably followed by rinsing with water to remove any residual etchant.

### Plating

An plating resist is provided on a surface of a substrate by applying and curing the radiation curable composition on the surface thereby forming a cured image on the surface. Metal is then plated on the surface of the substrate not covered by the cured image. After plating, the cured image is then, at least partially, removed by means of an acidic solution.

Metal plating is the opposite of etching. Where etching removes metal from a metallic surface, metal plating deposits metal on a surface of a substrate.

In a metal plating process, a thin layer of a metal is deposited on a substrate. The substrate may be a metal or another material. Metal plating is used to decorate objects, for corrosion inhibition, to improve solderability, to harden, to improve wearability, to reduce friction, to improve paint adhesion, to alter conductivity, to improve IR reflectivity, for radiation shielding, and for other purposes.

Metal plating may be achieved by electroplating or by electroless plating.

Electroplating is a process that uses an electric current to reduce dissolved metal cations so that they form a thin metal coating on a substrate. The substrate acts as the cathode in the process.

Examples of a metal which may be used in an electroplating process include copper, chrome, lead, nickel, gold, silver, tin, and zinc.

The thickness of the metal layer deposited obtained by electroplating may vary according to the intended use, and can be controlled by adjusting the concentration of the metal contained in the plating bath, the current density, or the like.

Electroless plating, also known as chemical or auto-catalytic plating, is a plating method that involves a chemical reaction in an aqueous solution without the use of external electrical power. The aqueous solution for the electroless process needs to contain the ions of the intended metal to be deposited and a reducing agent so that a chemical reaction can occur which has the form: ${M}^{z +} + {RED}_{solution} {\to }^{catalytle_surface} {M}_{solid} + {OXY}_{solution}$

In the present invention, the catalytic surface is the metallic surface not protected by any UV cured image and M_{solid} is the metal deposited on the metallic surface of the metallic substrate.

In principle any hydrogen-based reducer can be used although the redox potential of the reducer half-cell must be high enough to overcome the energy barriers inherent in liquid chemistry. For example, electroless nickel plating generally uses hypophosphite as the reducer while plating of other metals like silver, gold and copper typically use low molecular weight aldehydes.

A major benefit of this approach over electroplating is that power sources and plating baths are not needed, reducing the manufacturing cost. The technique can also plate diverse shapes and types of surface. The downside is that the plating process is usually slower and cannot create such thick deposits of metal.

Generally, the electroless plating bath includes as main components, in addition to a solvent,
1. a metal ion for plating,
2. a reducing agent, and
3. an additive (stabilizer) that enhances the stability of the metal ions.

This plating bath may further contain a known additive, in addition to the above components.

There is no limitation on the metal ion used for plating. Frequently used metal ions include copper, tin, lead, nickel, gold, palladium, and rhodium.

The organic solvent used in the plating bath is preferably a solvent that is soluble in water, and from this point of view, ketones such as acetone, or alcohols such as methanol, ethanol, or isopropanol are preferably used

There are preferable reducing agents and additives according to the type of the metal. These reducing agents are well-known in the art of conventional electroless plating and include e.g. boron-based reducing agents such as sodium borohydride or dimethylamine borane, and reducing agents such as formaldehyde or hypophosphorous acid.

For example, an electroless plating bath used for electroless plating of copper preferably includes CuSO4 as the salt of copper, HCOH as the reducing agent, and a chelating agent that serves as a stabilizer of the copper ion, such as ethylenediaminetetraacetic acid (EDTA) or Rochelle salt, trialkanolamine, or the like, as the additive.

An electroless plating bath used for electroless plating of CoNiP preferably includes cobalt sulfate and nickel sulfate as the metal salts thereof, sodium hypophosphite as the reducing agent, and sodium malonate, sodium malate, or sodium succinate as the complexing agent.

An electroless plating bath used for electroless plating of palladium preferably includes (Pd(NH3)4)CI2 as the metal ion, NH3 or H2NNH2 as the reducing agent, and EDTA as the stabilizer.

These plating baths may further include components other than the above components.

The plating bath preferably has a pH between 8 and 14, preferably a pH of at least 9, more preferably at least 10, most preferably at least 11.

Metal plating is widely used in the production of Printed Circuit Boards (PCB). For example Through-holes (Thru-holes) and/or via's in PCBs are rendered conductive by Copper plating.

### Removal of etch or plating resist

After etching or plating, the cured radiation composition must at least partially be removed from the surface. In a preferred embodiment, the cured radiation curable composition is completely removed from the surface.

The removal may be accomplished by stripping or solubilizing the cured radiation composition.

The cured radiation curable composition according to the present invention is removed by an acidic bath. Such an acidic stripping bath is usually an aqueous solution having a pH between 2 and 5, preferably having a pH of less than 4, more preferably less than 2.5, most preferably less than 1.5.

### 3D printing

The radiation curable composition described above may be used as support in a 3D manufacturing printing method, for example 3D inkjet printing.

A support is used to temporarily support parts of the 3D printed objects before they are fully cured. Once the object is fully cured, the support has then to be removed.

The printing method for manufacturing a Three Dimensional (3D) object (10) includes the steps of:
- printing a support (15) associated with at least part of the 3D object using a radiation curable composition as described above; and
- removing (20) at least part of the support by means of an acidic solution.

The inkjet ink used to print the 3D object must ensure that the acidic solution used to remove the support, does not substantially solubilize the 3D object.

### Inkjet Printing Devices

The radiation curable inkjet ink may be jetted by one or more print heads ejecting small droplets in a controlled manner through nozzles onto a substrate, which is moving relative to the print head(s).

A preferred print head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the print head creating a void, which is then filled with ink. When the voltage is again removed, the ceramic expands to its original shape, ejecting a drop of ink from the print head. However the inkjet printing method according to the present invention is not restricted to piezoelectric inkjet printing. Other inkjet print heads can be used and include various types, such as a continuous type.

The inkjet print head normally scans back and forth in a transversal direction across the moving ink-receiver surface. Often the inkjet print head does not print on the way back. Bi-directional printing is preferred for obtaining a high areal throughput. Another preferred printing method is by a "single pass printing process", which can be performed by using page wide inkjet print heads or multiple staggered inkjet print heads which cover the entire width of the ink-receiver surface. In a single pass printing process the inkjet print heads usually remain stationary and the ink-receiver surface is transported under the inkjet print heads.

### Curing Devices

The radiation curable inkjet ink can be cured by exposing them to actinic radiation, such as electron beam or ultraviolet radiation. Preferably the radiation curable inkjet ink is cured by ultraviolet radiation, more preferably using UV LED curing.

In inkjet printing, the curing means may be arranged in combination with the print head of the inkjet printer, travelling therewith so that the curable liquid is exposed to curing radiation very shortly after been jetted.

In such an arrangement, with the exception of UV LEDs, it can be difficult to provide a small enough radiation source connected to and travelling with the print head. Therefore, a static fixed radiation source may be employed, e.g. a source of curing UV-light, connected to the radiation source by means of flexible radiation conductive means such as a fibre optic bundle or an internally reflective flexible tube.

Alternatively, the actinic radiation may be supplied from a fixed source to the radiation head by an arrangement of mirrors including a mirror upon the radiation head.

The source of radiation may also be an elongated radiation source extending transversely across the substrate to be cured. It may be adjacent the transverse path of the print head so that the subsequent rows of images formed by the print head are passed, stepwise or continually, beneath that radiation source.

Any ultraviolet light source, as long as part of the emitted light can be absorbed by the photo-initiator or photo-initiator system, may be employed as a radiation source, such as, a high or low pressure mercury lamp, a cold cathode tube, a black light, an ultraviolet LED, an ultraviolet laser, and a flash light. Of these, the preferred source is one exhibiting a relatively long wavelength UV-contribution having a dominant wavelength of 300-400 nm. Specifically, a UV-A light source is preferred due to the reduced light scattering therewith resulting in more efficient interior curing.

UV radiation is generally classed as UV-A, UV-B, and UV-C as follows:
- UV-A: 400 nm to 320 nm
- UV-B: 320 nm to 290 nm
- UV-C: 290 nm to 100 nm.

In a preferred embodiment, the radiation curable inkjet ink is cured by UV LEDs. The inkjet printing device preferably contains one or more UV LEDs preferably with a wavelength larger than 360 nm, preferably one or more UV LEDs with a wavelength larger than 380 nm, and most preferably UV LEDs with a wavelength of about 395 nm.

Furthermore, it is possible to cure the ink image using, consecutively or simultaneously, two light sources of differing wavelength or illuminance. For example, the first UV-source can be selected to be rich in UV-C, in particular in the range of 260 nm-200 nm. The second UV-source can then be rich in UV-A, e.g. a gallium-doped lamp, or a different lamp high in both UV-A and UV-B. The use of two UV-sources has been found to have advantages e.g. a fast curing speed and a high curing degree.

For facilitating curing, the inkjet printing device often includes one or more oxygen depletion units. The oxygen depletion units place a blanket of nitrogen or other relatively inert gas (e.g. CO₂), with adjustable position and adjustable inert gas concentration, in order to reduce the oxygen concentration in the curing environment. Residual oxygen levels are usually maintained as low as 200 ppm, but are generally in the range of 200 ppm to 1200 ppm.

### EXAMPLES

### Materials

All materials used in the following examples were readily available from standard sources such as ALDRICH CHEMICAL Co. (Belgium) and ACROS (Belgium) unless otherwise specified. The water used was deionized water.

**ACMO** is acryloyl morpholine available from Rahn.

**ITX** is Speedcure™ ITX, a mixture of isopropyl thioxanthone isomers from LAMBSON SPECIALTY CHEMICALS.

**EHA** is 4-dimethylamine-benzoic acid 2-ethyl-hexyl ester available from as Genocure™ EHA from Rahn.

**BAPO** is bis(2,4,6-trimethylbenzoyl)-phenylphosphineoxide photoinitiator available as Irgacure™ 819 from BASF

**Contrast** is Macrolex blue 3R supplied by Bayer A.G..

**Amine-1** was supplied by Aldrich.

**Amine-7** was supplied by TCI Europe.

### Methods

### Thin Layer Chromatography - Massa Spectroscopy (TLC-MS)

The molecular mass was determined using TLC-MS according to the following procedure.

A TLC was run under circumstances given in the synthetic examples.

The TLC was analyzed using a CAMAG TLC-MS interface coupled to an AmaZon SL mass spectrometer (supplied by Brüker Daltonics) via an Agilent 1100 HPLC pump.

First a blank spectrum was taken by eluting a spot on the TLC plate where no compounds are present with a 0.01 molar solution of ammonium acetate in methanol.

A second spectrum of the compound to be analyzed was taken by eluting the spot of the compound under consideration with a 0.01 molar solution of ammonium acetate in methanol.

The first spectrum was subtracted from the second spectrum, giving the spectrum of the compound to be analyzed.

### Preparation of difunctional monomers including an acid degradable group

### 2-[2-[1-(2-prop-2-enoy)oxyethoxy)ethoxy]ethoxy]ethy prop-2-enoate (crosslinker-1)

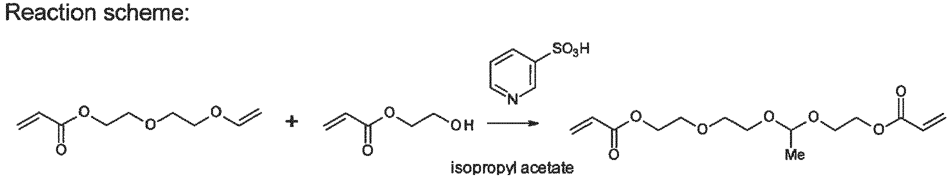

25 g (0.134 mol) 2-(2-vinyloxyethoxy)ethyl acrylate was dissolved in 60 ml isopropyl acetate. 15.6 g (0.134 mol) 2-hydroxyethyl acrylate, 2.136 g (13.4 mmol) 3-pyridine sulfonic acid and 0.59 g BHT were added and the mixture was then heated to 85°C.

The reaction was allowed to continue at 85°C for 7 hours.

An additional 1.56 g (13.4 mmol) 2-hydroxyethyl acrylate was added and the reaction was continued for an additional hour at 85°C.

After cooling the reaction mixture to room temperature, the reaction was allowed to continue at room temperature for 16 hours.

The catalyst was removed by filtration and the solvent was evaporated under reduced pressure.

2-[2-[1-(2-prop-2-enoyloxyethoxy)ethoxy]ethoxy]ethyl prop-2-enoate was purified by preparative column chromatography on a Graceresolve column, supplied by Büchi, using a gradient elution from methylene chloride to methylene chloride/ethyl acetate 50/50.

12.7 g of 2-[2-[1-(2-prop-2-enoyloxyethoxy)ethoxy]ethoxy]ethyl prop-2-enoate was isolated (yield = 31%).

2-[2-[1-(2-prop-2-enoyloxyethoxy)ethoxy]ethoxy]ethyl prop-2-enoate was analyzed using TLC on a TLC Silica get 60F254 plate, supplied by Merck (eluent methylene chloride/ethyl acetate 80/20, Rf : 0.5). The molecular weight was confirmed using TLC coupled to mass spectroscopy according to the method described above.

### (1,1,4-trimethyl-4-prop-2-enoyloxy-pentyl) prop-2-enoate (crosslinker-6)

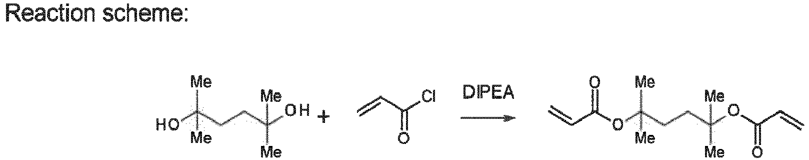

18 g (0.123 mol) 2,5-dimethyl-2,5-hexanediol was dissolved in 100 ml methylene chloride. 53,5 ml (0.307 mol) di-isopropyl ethyl amine was added. A solution of 25.6 g (0.283 mol) acryloyl chloride in 50 ml dichloromethane was added over 30 minutes. 542 mg BHT was added and the reaction was allowed to continue for 24 hours at room temperature.

The mixture was diluted with 500 ml methyl t.butyl ether. The precipitated salts were removed by filtration and the solvent was evaporated under reduced pressure.

(1,1,4-trimethyl-4-prop-2-enoyloxy-pentyl) prop-2-enoate was purified by preparative column chromatography on a Graceresolve column, supplied by Büchi, using a gradient elution from methylene chloride/hexane 60/40 to methylene chloride.

18.3 g (yield = 58%) of (1,1,4-trimethyl-4-prop-2-enoyloxy-pentyl) prop-2-enoate was isolated.

(1,1,4-trimethyl-4-prop-2-enoyloxy-pentyl) prop-2-enoate was analyzed using TLC on a TLC Silica gel 60F254 plate, supplied by Merck (eluent methylene chloride/ethyl acetate 95/5, Rf : 0.55). The molecular weight was confirmed using TLC coupled to mass spectroscopy according to the method described above.

### [1-methyl-1-[3-(1-methyl-1-prop-2-enoyloxy-ethyl)phenyl]ethyl]prop-2-enoate (crosslinker-7)

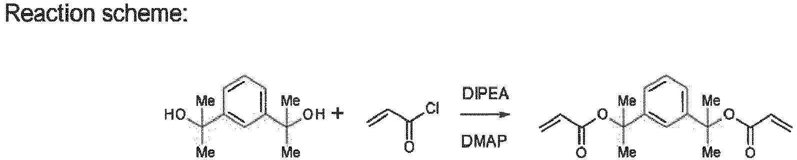

18 g (0.0926 mol) 1,3-di(2-hydroxy-2-propyl)benzene was dissolved in 100 ml methylene chloride. 43.5 ml (0.25 mol) di-isopropyl-ethyl-amine was added. A solution of 20.96 g (0.232 mol) acryloyl chloride in 40 ml methylene chloride was added over 30 minutes. The reaction was allowed to continue for 20 hours at room temperature.

The solvent was removed under reduced pressure and [1-methyl-1-[3-(1-methyl-1-prop-2-enoyloxy-ethyl)phenyl]ethyl] prop-2-enoate was purified by preparative column chromatography on a Graceresolve column, supplied by Büchi, using methylene chloride as eluent.

15 g (yield = 53%) of [1-methyl-1-[3-(1-methyl-1-prop-2-enoyloxy-ethyl)phenyl]ethyl] prop-2-enoate was isolated.

[1-methyl-1-[3-(1-methyl-1-prop-2-enoyloxy-ethyl)phenyl]ethyl]prop-2-enoate was analyzed using TLC on a TLC Silica gel 60F254 plate, supplied by Merck, eluent methylene chloride, Rf : 0.3). The molecular weight was confirmed using TLC coupled to mass spectroscopy according to the method described above.

### Preparation of a nitrogen containing monofunctional monomer

The synthesis of 3-pyridylmethyl prop-2-enoate (amine-11)

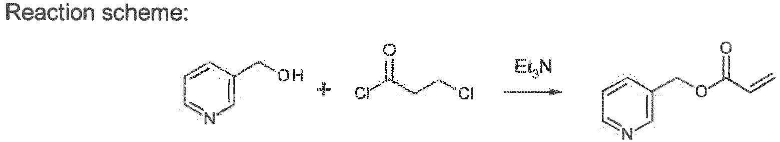

40 g (0.36 mol) 3-(hydroxymethyl)pyridine was dissolved in 600 ml methyl t.butyl ether. 101 ml (0.72 mol) triethyl amine was added and the mixture was cooled to - 4°C. 46 g (0.36 mol) 3-chloropropionyl chloride was added over 45 minutes while keeping the temperature between 0 and 5°C. The reaction was allowed to continue for 48 hours at room temperature.

500 ml water was added and the methyl t.butyl ether fraction was isolated. The methyl t.butyl ether fraction was extracted with 300 ml water. The pooled water fractions were extracted with 300 ml methyl t.butyl ether. The pooled methyl t.butyl ether fractions were dried over MgSO4 and the solvent was evaporated under reduced pressure. The crude 3-pyridylmethyl prop-2-enoate was purified by preparative column chromatography on a Graceresolve column, supplied by Buchi, using a gradient elution from hexane/methylene chloride 50/50 to hexane/ethyl acetate 50/50. 11.2 g (y : 19%) of 3-pyridylmethyl prop-2-enoate was isolated. 3-pyridylmethyl prop-2-enoate was analyzed using TLC on a TLC Silica gel 60F254 plate, supplied by Merck (eluent hexane/ethyl acetate 50/50, Rf : 0.8).

### Example 1

The inventive radiation curable composition INV-1 and comparative composition COMP-1 were prepared according to Table 3. The weight percentages (wt%) are all based on the total weight of the radiation curable composition.

**Table 3**

| **wt% of component** | **INV-1** | **COMP-1** |
|---|---|---|
| **Crosslinker-1** | 49.7 | 49.7 |
| **ACMO** | 32 | 37 |
| **Amine-1** | 5 | - |
| **ITX** | 5 | 5 |
| **EHA** | 5 | 5 |
| **BAPO** | 3 | 3 |
| **contrast** | 0.3 | 0.3 |

The inventive composition INV-1 and comparative composition COMP-2 were coated on an anodized aluminum using a 10 µm wired bar thereby covering part of the aluminum surface. The coatings were cured on a Aktiprint Mini, supplied by Technigraf, at a belt speed of 20 m/min and with the lamp being at the second lowest position. The coatings were considered as fully cured the moment they could no longer be damaged by a Q-tip. The inventive composition INV-1 and comparative coating COMP-1 proved to be fully cured in one pass.

The partially coated aluminum strips were first etched in a 0.25 M NaOH solution, having a pH of 12.55, for 10 minutes at room temperature.

The strips were then rinsed with demineralized water, followed by dipping the strips in a 0.07 M NaHSO4 / 0.09M H2SO4-solution for 10 minutes at room temperature. The samples were rinsed with demineralized water.

The alkaline resistance and the acid strippability were judged visually and scored from 0 to 5 using the following criteria:
- alkaline resistance: 5 = complete removal and etching of the aluminium; 0 = full alkaline resistance;
- acid strippability: 5 = full acid resistance; 0 full removal upon acid stripping.

A score of 2 or less for both alkaline etch resistance and strippability are considered as being useful in the application.

The results of inventive composition INV-1 and comparative composition COMP-1 are summarized in Table 4.

**Table 4**

| | Alkaline resistance | Acid strippability |
|---|---|---|
| INV-1 | 0 | 0 |
| COMP-1 | 0 | 5 |

From Table 4 it becomes clear that only the formulation according to the present invention is performing well as etch resist.

### Example 2

The inventive radiation curable composition INV-2 and INV-3 were prepared according to Table 5. The weight percentages (wt%) are all based on the total weight of the radiation curable composition.

**Table 5**

| **wt% of component** | **INV-2** | **INV-3** |
|---|---|---|
| **Crosslinker -1** | 50 | 50 |
| **ACMO** | 32 | 32 |
| **Amine-7** | 5 | - |
| **Amine-11** | - | 5 |
| **ITX** | 5 | 5 |
| **EHA** | 5 | 5 |
| **BAPO** | 3 | 3 |

The inventive compositions INV-2 and INV-3 were coated on an anodized aluminum, using a 10 micron wired bar, thereby covering part of the aluminum.

The coatings were cured on a Aktiprint Mini, supplied by Technigraf, at a belt speed of 20 m/min and with the lamp being at the second lowest position. The coatings were considered as fully cured the moment they could no longer be damaged by a Q-tip.

The inventive compositions INV-2 and INV-3 proved to be fully cured in one pass.

The partially coated aluminum strips were first etched in a 0.25 M NaOH solution, having a pH of 12.55, for 10 minutes at room temperature. The strips were then rinsed with demineralized water, followed by dipping the strips in a 0.07 M NaHSO4/0.09M H2SO4 solution for 10 minutes at room temperature. The samples were rinsed with demineralized water.

The alkaline resistance and the acid strippability was judged visually as described above in example 1 and shown in Table 6.

**Table 6**

| | Alkaline resistance | Acid strippability |
|---|---|---|
| INV-2 | 0 | 0 |
| INV-3 | 0 | 0 |

From Table 6 it becomes clear that different polymerizable amines can be used in the radiation curable resists according to the present invention.

### Example 3

This example illustrates the use of tertiary esters as acid degradable linking group in radiation curable compositions according to the present invention.

The inventive radiation curable compositions INV-4 and INV-5 and comparative compositions COMP-2 and COMP-3 were prepared according to Table 7. The weight percentages (wt%) are all based on the total weight of the radiation curable composition.

**Table 7**

| **wt% of component** | **INV-4** | **INV-5** | **COMP-2** | **COMP-3** |
|---|---|---|---|---|
| **Crosslinker -6** | 25 | - | 25 | - |
| **Crosslinker-7** | - | 25 | - | 25 |
| **ACMO** | 57 | = | 62 | 62 |
| **Amine-1** | 5 | = | - | - |
| **ITX** | 5 | = | = | = |
| **EHA** | 5 | = | = | = |
| **BAPO** | 3 | = | = | = |

The inventive compositions INV-4 and INV-5 and comparative composition COMP-2 and COMP-3 were coated on an anodized aluminum, using a 10 micron wired bar, thereby covering part of the aluminum. The coatings were cured on a Aktiprint Mini, supplied by Technigraf, at a belt speed of 20 m/min and with the lamp being at the second lowest position. The coatings were considered as fully cured the moment they could no longer be damaged by a Q-tip. All compositions proved to be fully cured in one pass.

The partially coated aluminum strips were first etched in a 0.25 M NaOH solution for 10 minutes at room temperature. The strips were then rinsed with demineralized water, followed by dipping the strip in a 0.49 M methane sulfonic acid solution for 10 minutes at room temperature.

The samples were rinsed with demineralized water.

The alkaline resistance and the acid strippability was judged visually as described above in example 1 and shown in Table 8.

**Table 8**

| | Alkaline resistance | Acid strippability |
|---|---|---|
| INV-4 | 0 | 0 |
| INV-5 | 0 | 0 |
| COMP-2 | 0 | 5 |
| COMP-3 | 0 | 3 |

From Table 8 it becomes clear that only the formulation according to the present invention is performing well as etch resist.

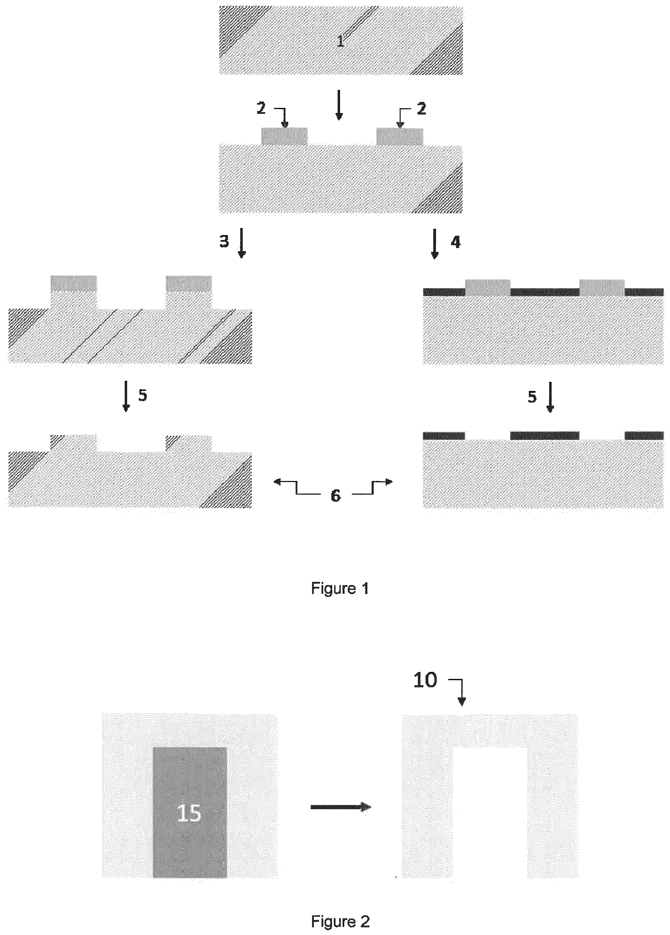

## Claims

1. A radiation curable composition comprising:
- a monomer including at least two polymerisable groups wherein a linking group between the polymerisable groups comprises at least one acid degradable or hydrolysable group selected from the group consisting of an acetal, a ketal, an orthoester, an orthocarbonate, a tertiary ester, a tertiary carbonate and a tertiary urethane, and
- a nitrogen containing monofunctional monomer of which the pKa of the conjugated acid is at least 3.5, and
wherein the composition further comprises less than 10 wt% of other monomers including at least two polymerisable groups relative to the total weight of the polymerisable composition.

2. The radiation curable composition according to claim 1 wherein the acid degradable or hydrolysable group is an acetal or a ketal.

3. The radiation curable composition according to claim 1 or 2 wherein the polymerisable groups are selected from the group consisting of an acrylate, a methacrylate, an acrylamide and a methacrylamide.

4. The radiation curable composition according to any of the preceding claims wherein the nitrogen containing monomer is functionalized with at least one functional group selected from the group consisting of a tertiary amine, a pyridine and an imidazole group.

5. The radiation curable composition according to any of the preceding claims wherein the pKa of the conjugated acid is at least 9.

6. The radiation curable composition according to any of the preceding claims wherein the monomer, including at least two polymerisable groups and wherein the linking group between the polymerisable groups comprises at least one acid degradable or hydrolysable group, has a chemical structure according to Formula I, 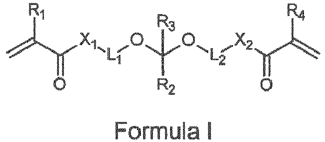 wherein
R₁ and R₄ are independently selected from the group consisting of a hydrogen and a C₁ to C₄ alkyl group;
R₂ and R₃ are independently selected from the group consisting of a hydrogen, a substituted or unsubstituted alkyl group, a substituted or unsubstituted alkenyl group, a substituted or unsubstituted alkynyl group and a substituted or unsubstituted (hetero)aryl group;
R₂ and R₃ may represent the necessary atoms to form a five to eight membered ring;
L₁ and L₂ independently represent a divalent linking group comprising 10 carbon atoms or less;
X₁ and X₂ are independently selected from the group consisting of an oxygen and RsN;
R₅ is selected from the group consisting of a hydrogen and a substituted or unsubstituted alkyl group.

7. The radiation curable composition according to any of the preceding claims wherein the monomer, including at least two polymerisable groups and wherein the linking group between the polymerisable groups comprises at least one acid degradable or hydrolysable group, has a chemical structure according to Formula II: 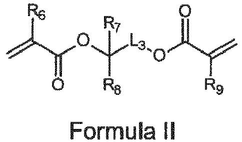 wherein
R₆ and R₉ are independently selected from the group consisting of a hydrogen and a C₁ to C₄ alkyl group;
R₇ and R₈ are independently selected from the group consisting of a substituted or unsubstituted alkyl group, a substituted or unsubstituted alkenyl group, a substituted or unsubstituted alkynyl group and a substituted or unsubstituted (hetero)aryl group;
R₇ and R₈ may represent the necessary atoms to form a five to eight membered ring; L₃ represent represent a divalent linking group comprising 20 carbon atoms or less.

8. A method of manufacturing metallic articles (6) including the steps of:
- applying a radiation curable composition as defined in any of the claims 1 to 7 on a surface of a substrate thereby forming an image (2);
- curing the image;
- plating (4) or etching (3) a surface of the substrate not covered by the cured image by means of an alkaline solution;
- removing (5) the cured image by means of an acidic solution.

9. The method according to claim 8 wherein curing is carried out using UV radiation.

10. The method according to claim 8 or 9 wherein the alkaline solution has a pH between 9 and 14.

11. The method according to any of the claims 8 to 10 wherein the pH of the acidic solution is between 2 and 5.

12. A printing method for manufacturing a Three Dimensional (3D) object (10) including the steps of:
- printing a support (15) associated with at least part of the 3D object using a radiation curable composition as defined in any of the claims 1 to 7; and
- removing at least part of the support by means of an acidic solution.

13. The use of the manufacturing method according to any of the claims 9 to 11 to manufacture an electronic device.

14. The use according to claim 13 wherein the electronic device is a Printed Circuit Board (PCB).

15. The use of the manufacturing method according to any of the claims 9 to 11 for decorative purposes.
